# EUROPEAN PATENT APPLICATION

(11) **EP 1 801 863 A1**
(43) Date of publication of application: **27.06.2007**
(21) Application number: 05781511.0
(22) Date of filing: 30.08.2005
(51) Int. Cl.: H01L 21/322, H01L 21/205, H01L 27/146

(54) **SILICON EPITAXIAL WAFER AND METHOD FOR MANUFACTURING THE SAME**

(30) Priority: 31.08.2004 JP 2004251837
(71) Applicant: SUMCO Corporation, Tokyo 105-8634 (JP)
(72) Inventor: SADAMITSU, Shinsuke c/o SUMCO CORPORATION, Minato-ku Tokyo 1058634 (JP); HOURAI, Masataka c/o SUMCO CORPORATION, Minato-ku, Tokyo 1058634 (JP)
(74) Representative: Albrecht, Thomas
(86) International application number: PCT/JP2005/015801
(87) International publication number: WO 2006/025409

(57) **Abstract**

A silicon epitaxial wafer of the invention comprises a silicon single crystal wafer sliced from a CZ silicon ingot doped with carbon in a concentration range of not less than 5×10¹⁵atoms/cm³ and not more than 5×10¹⁷atoms/cm³ and an epitaxial layer consisting of a silicon single crystal epitaxially grown on a front surface of the silicon single crystal wafer. A polycrystalline silicon layer having a thickness of not less than 0.5 µm and not more than 1.5 µm is formed on a back surface of the silicon single crystal wafer.

## Description

### TECHNICAL FIELD

The present invention relates to a silicon epitaxial wafer (hereafter referred to as an epi-wafer) which can be suitably applied to a CCD (Charge Coupled Device), CMOS (Complementally Metal-Oxide Semiconductor) or the like. Priority is claimed on Japanese Patent Application No. 2004-251837, filed August 31, 2004, the content of which is incorporated herein by reference.

### BACKGROUND ART

In accordance with the recent circulation of digital cameras or the like, there has been a rapid increase in the production of imaging elements such as CCD devices and CMOS imaging censors. Where a white defect occurs in an imaging element, an image cannot be captured at the position of the white defect. Therefore, a white defect causes a problem of reducing the yield of the imaging device.

It is known that the white defect is caused by contamination of heavy metals in a silicon wafer. Conventionally, a DG-IG epi-wafer having an extremely high internal gettering effect has been used for imaging devices. A DG-IG epi-wafer is formed by epitaxial growth of a silicon single crystal on a surface of a silicon wafer (DZ-IG wafer) which has been subjected to Denuded Zone-Intrinsic Gettering (DZ-IG) treatment. An imaging substrate is required to have a strong gettering effect so as to eliminate heavy metal contamination. It is known that an IG wafer must have oxide precipitates with high density of not less than 5×10⁹ particles/cm³ when the IG wafer is used for producing an imaging substrate. A DZ-IG wafer is produced by a two-step heat treatment comprising a DZ heat treatment at a temperature of about 1100°C to 1200°C to convert a surface layer of a wafer to a defect-free layer by outer diffusion of oxygen, and an IG heat treatment at a temperature of 600°C to 900°C to form oxygen precipitation nuclei within the wafer. Since the DG-IG heat treatment generally requires a treatment time of 10 hours or more, the production cost of the DG-IG wafer is expensive. In addition, the DZ heat treatment performed at a high temperature has allowed a possibility of contamination of the wafer with heavy metals during the heat treatment. Therefore, the DZ-IG wafer produced using the DZ-IG wafer also had a problem of high production cost and the occurrence of heavy metal contamination during the heat treatment.

Expedients to solve the above-described problem have been proposed. For example, in a method for producing a silicon wafer disclosed in Patent Reference 1 (Japanese Unexamined Patent Application, First Publication No. H10-229093), a silicon wafer is pulled by the Czochralski method (CZ method) while controlling the oxygen concentration to be in a range from 12 to 18×10¹⁷atoms/cm³(ASTM F121-1979), and carbon concentration to be in a range from 0.3 to 2.5×10¹⁵atoms/cm³ (ASTM F123-1981). After slicing a silicon wafer from the silicon single crystal, the wafer is subjected to an annealing treatment at a temperature of not lower than 600°C and not higher than 900°C for a duration of not shorter than 15 minutes and not longer than 4 hours. Without subjecting the wafer to a treatment intended to cause an Extrinsic Gettering (EG) effect, one side or both sides of the wafer are mirror polished, and an epitaxial film is formed on the surface of the wafer.

In a method for producing an epitaxial wafer disclosed in Patent Reference 2 (Japanese Unexamined Patent Application, First Publication H11-204534), a silicon single crystal is pulled by the CZ method or by the MCZ method while controlling the carbon concentration to be in a range from 0.1 to 2.5×10¹⁵atoms/cm³(ASTM F123-1981), and oxygen concentration to be in a range from 10 to 18×10¹⁷atoms/cm³ (ASTM F121-1979), and a silicon wafer for a semiconductor device is sliced from the single crystal. One side or both sides of the wafer is mirror polished and an epitaxial silicon film is formed on the surface of the wafer. After that, the wafer is subjected to a heat treatment for forming micro defects in the interior portion of the wafer.

For example, Patent Reference 3 (Japanese Unexamined Patent Application, First Publication No. 2001-237247) discloses a method for producing an epi-wafer, comprising an epitaxial growth on a carbon-doped CZ wafer at a temperature below 1000°C. Using the methods described in Patent References 1 through 3, it is possible to obtain an epi-wafer which exhibits sufficient IG effect during a device process under low temperature conditions.

There is a method disclosed for producing a semiconductor device, comprising a step of forming an EG layer on the back surface of a semiconductor wafer and a step of implanting elements constituting oxygen precipitation nuclei into an interstitial portion between the EG layer and element-forming region of the semiconductor wafer (for example, Patent Reference 4: Japanese Patent Publication No. 3203740). In the method described in Patent Reference 4, it is possible to provide the semiconductor device with a gettering ability having high durability and therefore highly enhance the yield of the device.

In a method for producing an epitaxial wafer disclosed in Patent Reference 5 (Japanese Patent Publication No. 3173106), after cleaning a semiconductor substrate, an protection film for inhibiting impurity-contamination is formed on the surface of the semiconductor substrate. Then, by introducing impurities to the backside surface layer of the semiconductor substrate, a gettering layer consisting of a highly concentrated impurity diffused layer is thereby formed. After removing the impurity-protection film and cleaning the semiconductor substrate, an epitaxial layer is deposited on the surface of the semiconductor substrate. In the method described in Patent Reference 5, since the gettering layer is formed of a highly concentrated impurity diffused layer, gettering is performed strongly.

### DISCLOSURE OF INVENTION

### [Problems to be solved by the invention]

In an equivalent heat treatment for simulating a production process for CCD, epi-wafers obtained by the methods of the above-described Patent Reference 1 through 3 generated oxide precipitates to a density similar to that of the conventionally-used DG-IG epi-wafer. However, compared with the conventional DZ-IG epi-wafer, the above-described wafers had a relatively smaller density of oxide precipitates during the early stage of device formation. The results indicate that the above-described epi-wafers have an IG effect equivalent to the DG-IG epi-wafer during and after an intermediate stage of the device production process, but during the early stage, have an IG effect inferior to that of the De-IG epi-wafer.

In the method described in Patent Reference 4, high cost and long duration required for the ion implantation are economically undesirable, and a sufficient gettering effect cannot be obtained since the oxygen precipitation region is limited to a region having a very narrow distribution in the depth direction. The method described in Patent Reference 5 cannot achieve a sufficient gettering effect since the oxygen precipitation region is limited to the gettering layer formed on the back surface of the substrate.

An object of the present invention is to provide a silicon epitaxial wafer and a method for producing the same which can be produced with lower production cost than that of the DG-IG wafer, has an excellent gettering effect, and is free of heavy metal contamination.

Another object of the present invention is to provide a silicon epitaxial wafer and a method for producing the same which exhibits a strong gettering effect from the early stage of a production process of an imaging device.

### [Expedients for solving the problem]

In order to solve the above-described problem, the inventors formed a polycrystalline silicon layer on the backside of a carbon-doped wafer so as to provide an EG effect. After the formation of the polycrystalline silicon layer, an epitaxial layer was formed on a surface of the wafer by epitaxial growth. Thus, a silicon epitaxial wafer of the present invention was produced.

A first aspect of the invention is an improved configuration of a silicon epitaxial wafer comprising a silicon single crystal wafer sliced from a CZ silicon ingot doped with carbon in a range of not less than 5×10¹⁵atoms/cm³ and not more than 5×10¹⁷atoms/cm³ (ASTM F123-1981) and an epitaxial layer consisting of a silicon single crystal grown epitaxially on a front surface of the silicon single crystal wafer. In this aspect, a polycrystalline silicon layer having a thickness of not less than 0.5 µm and not more than 1.5 µm is formed on a back surface of the silicon single crystal wafer.

In the early stage of the production process of an imaging device, the silicon epitaxial wafer according to the first aspect generates oxide precipitates of 5×10⁹ particles/cm³ or more, and therefore has sufficient IG effect. In addition, an EG effect is added by the polycrystalline silicon layer. Therefore, the silicon epitaxial wafer has an optimum applicability to the production of an imaging device which is sensitive to heavy metal contamination, and contributes to improvement of the yield.

A second aspect of the present invention is a method for producing a silicon epitaxial wafer, comprising: preparing a silicon single crystal wafer sliced from a CZ silicon ingot doped with carbon in a range of not less than 5×10¹⁵atoms/cm³ and not more than 5×10¹⁷atoms/cm³ (ASTM F123-1981); forming a polycrystalline silicon layer having a thickness of not less than 0.5 µm and not more than 1.5 µm on a back surface of the silicon single crystal wafer and forming oxygen precipitation nuclei in an internal portion of the silicon single crystal wafer; and epitaxially growing an epitaxial layer consisting of a silicon single crystal on a front surface of the silicon single crystal wafer.

In the production method according to the second aspect, by performing the above-described steps in the above-described order, it is possible to produce epitaxial wafers at lower cost than that of the DZ-IG wafer. In addition, since there is no need for a high-temperature heat treatment, contamination with heavy metals does not occur during the production process of the wafer. In such an epitaxial wafer, it is possible to expect a strong gettering effect acting from the early stage of the production process of an imaging device.

### Effect of the invention

An epitaxial wafer of the present invention generates oxide precipitates of not less than 5×10⁹particles/cm³ in the early stage of the production process of an imaging device and therefore provides a sufficient IG effect. In addition, an EG effect is provided by the polycrystalline silicon layer. Therefore, the silicon epitaxial wafer has an optimum applicability to the production of an imaging device which is sensitive to heavy metal contamination, and contributes to improvement of the yield.

By a method for producing an epitaxial wafer according to the invention, it is possible to produce an epitaxial wafer at lower cost than that of the DZ-IG wafer, which requires high production cost and has a high possibility of heavy metal contamination occurring in its production process. In addition, since there is no need for a high-temperature heat treatment, contamination with heavy metals does not occur in the device production process and a strong gettering effect can be expected from the early stage of the production process of an imaging device.

### BRIEF DESCRIPTION OF THE DRAWINGS

FIGS. 1A through D are drawings showing a process chart of a method for producing a silicon epitaxial wafer of the present invention.
FIG. 2 is a graph showing a thermal profile of a DZ-IG two-step heat treatment of Comparative Example 1.
FIG 3 shows densities of oxide precipitates for each of device processing steps in the Comparative Testing 1.
FIG 4 is a graph showing efficiency percentage under evaluation testing of dielectric voltage of an oxide layer by TZDB in the Comparative Testing 2.

### Explanation of Symbols

- 10: silicon epitaxial wafer
- 11: silicon single crystal wafer
- 11a: oxygen precipitation nuclei
- 11b: oxide precipitate
- 12: polycrystalline silicon layer
- 13: epitaxial silicon layer

### BEST MODE FOR CARRYING OUT THE INVENTION

Next, a best mode for carrying out the invention is explained with reference to the drawings.

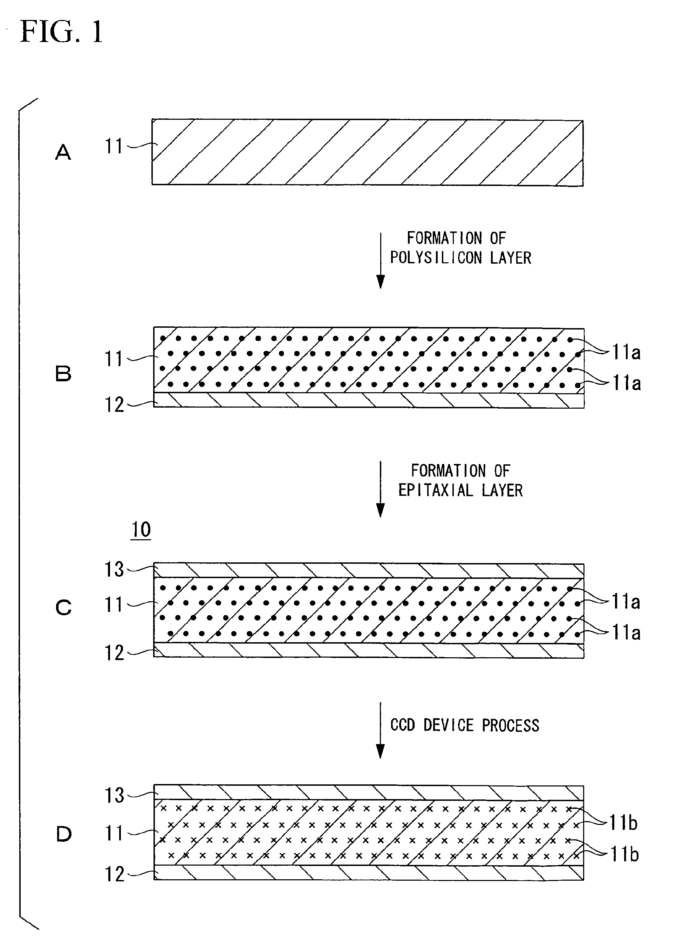

FIG. 1C shows a silicon epitaxial wafer of the invention having an improved configuration of a silicon epitaxial wafer 10 comprising a silicon single crystal wafer 11 sliced from a CZ silicon ingot doped with carbon in a range of not less than 5×10¹⁵atoms/cm³ and not more than 5×10¹⁷atoms/cm³ (ASTM F123-1981), and an epitaxial layer 13 of silicon single crystal formed by epitaxial growth on a front surface of the silicon single crystal wafer 11. On a back surface of the silicon single crystal wafer 11, a polycrystalline silicon layer 12 is formed so as to have a thickness of not less than 0.5µm and not more than 1.5µm.

By forming the polycrystalline silicon layer 12 on the back surface of the silicon single crystal wafer 11, in addition to the EG effect of the polycrystalline silicon layer 12, it is possible to obtain an effect of enhancing oxygen precipitation within the wafer by introducing vacancies from the polycrystalline silicon layer 12 into the interior of the silicon single crystal wafer 11. Therefore, numerous oxide precipitates are formed within the silicon single crystal wafer 11. By using such an epitaxial wafer, as shown in FIG 1D, oxide precipitates 11b of not less than 5×10⁹particles/cm³ are generated in the early stage of the production process of an imaging device. Since a sufficient IG effect can be obtained by the oxide precipitates, and an EG effect is provided by the polycrystalline silicon layer 12, the above-described silicon epitaxial wafer has an optimum applicability to the production of an imaging device which is sensitive to heavy metal contamination, and contributes to improvement of the yield.

Next, a method for producing a silicon epitaxial wafer according to the present invention is explained in the following. Firstly, as shown in FIG.1A, a silicon wafer 11 is prepared. The silicon wafer 11 has been sliced from a CZ silicon ingot doped with carbon in a range of not less than 5×10¹⁵atoms/cm³ and not more than 5×10¹⁷atoms/cm³ (ASTM F123-1981). Where the carbon concentration is less than 5×10¹⁵atoms/cm³, it is difficult to generate oxide precipitates of not less than 5×10⁹atoms/cm³ in the device process, resulting in insufficient gettering. Where the carbon concentration exceeds 5×10¹⁷atoms/cm³, it is impossible to grow a single crystal because of generation of dislocations in the crystal. Therefore, the concentration of doped carbon was set in a range of of not less than 5×10¹⁵atoms/cm³ and not more than 5×10¹⁷atoms/cm³ (ASTM F123-1981). Preferably, the concentration of doped carbon is in a range from 5×10¹⁵atoms/cm³ and not more than 5×10¹⁶atoms/cm³.

The oxygen concentration of the silicon wafer 11 is preferably in a range from 14 to 18×10¹⁷atoms/cm³(ASTMF121-1979). Where the oxygen concentration is less than 14×10¹⁷atoms/cm³, it is difficult to produce oxide precipitates of not less than 5×10⁹ atoms/cm³ in the device process, resulting in insufficient gettering. Where the oxygen concentration exceeds 18×10¹⁷atoms/cm³, epitaxial defects caused by the oxygen precipitation easily occur. Preferable oxygen concentration is in a range from 14 to 16×10¹⁷atoms/cm³. Specific resistivity of the silicon single crystal wafer 11 is not limited. Even a low resistivity substrate of about 0.1Ω·cm or less or a high resistivity substrate exceeding 100Ω·cm may be applied to the epitaxial wafer of the present invention. Preferably, at least a main surface of the single crystal wafer 11 used in the invention is mirror-polished.

Next, as shown in FIG.1B, a polycrystalline silicon layer 12 of average thickness of not less than 0.5µm and not more than 1.5µm is formed on the back surface of the silicon wafer 11, and oxygen precipitation nuclei 11a are formed in the silicon single crystal wafer 11. In general, it takes several hours at a temperature of about 650°C to form a polycrystalline silicon layer on the back surface of a silicon single crystal wafer. However, when a carbon-doped silicon single crystal wafer 11 is subjected to a heat treatment at a temperature of about 650°C, oxygen precipitation nuclei are formed within a very short period of time. In addition, by the formation of the polycrystalline silicon layer 12 on the back surface of the silicon single crystal wafer 11, vacancies are provided from the polycrystalline silicon layer 12 into the silicon single crystal wafer 11 and it is also possible to obtain the effect of enhancing oxygen precipitation in the wafer. Therefore, by the formation of the polycrystalline layer 12 on the back surface of the silicon single crystal wafer 11, numerous oxide precipitates are formed in the silicon single crystal wafer 11. The introduction of vacancies into the wafer interior from a polycrystalline silicon layer is also reported in Appl. Phys. Lett., Vo1.54, No.18, 1 May1989, p.1748-1750.

Where the thickness of the polycrystalline silicon layer 12 is less than 0.5 µm, it is impossible to obtain a sufficient EG effect. Where the thickness exceeds 1.5 µm, even though a sufficient EG effect can be provided, high production cost is required and warpage in the wafer occurs. Therefore, the thickness of the polycrystalline silicon layer was set in a range of not less than 0.5 µm and not more than 1.5 µm. Preferably, the thickness of the polycrystalline silicon layer 12 is from 0.8 to 1.2 µm.

Next, as shown in FIG. 1C, an epitaxial layer 13 consisting of a silicon single crystal is formed by epitaxial growth on the surface of the silicon single crystal wafer 11. Preferably, the epitaxial layer 13 has a thickness in a range from 5 to 20 µm.

By performing the above-described steps in the above-described order, a silicon epitaxial layer 10 of the present invention can be obtained. This epitaxial wafer can be produced at lower production cost than that of the DZ-IG wafer. In addition, since there is no need for a high temperature heat treatment, contamination with heavy metals does not occur in the device production process and strong gettering effect can be expected from the early stage of the production process of an imaging device.

### [Example]

Next, an example of the invention and comparative examples are explained in detail.

### Example 1

Firstly, a silicon ingot doped with P at a concentration of 4.4×10¹⁴atoms/cm³ and carbon at a concentration of 1×10¹⁶atoms/cm³(ASTM F123-1981), having an oxygen concentration of 15×10¹⁷atoms/cm³(ASTM F 121-1979), and having a resistvity of 10Ω·cm was grown by the CZ method. Then, n-type silicon wafers having a diameter of 8 inches were sliced from the ingot. Next, a polycrystalline silicon layer of 1 µm in thickness was formed on a backside of the silicon single crystal wafer. Next, on the front surface of the silicon single crystal wafer, an epitaxial layer of n-type silicon single crystal having a resistivity of 10 Ω·cm was epitaxially grown so as to have a thickness of 10µm. Thus, an epitaxial wafer was obtained.

### Comparative Example 1

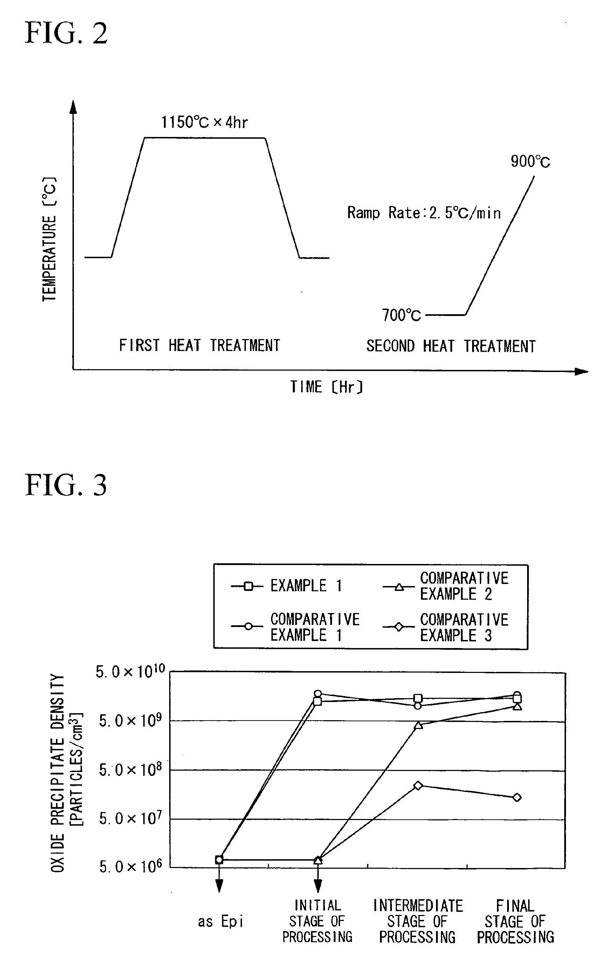

Firstly, a silicon ingot doped with P at a concentration of 4.4×10¹⁴ atoms/cm³, having an oxygen concentration of 15×10¹⁷atoms/cm³(ASTM F121-1979), and having a resistvity of 10Ω·cm was grown by the CZ method. Then n-type silicon wafers having a diameter of 8 inches were sliced from the ingot. Next, a DZ-IG wafer was formed by performing a DZ-IG two-step heat treatment comprising a first heat treatment and a second heat treatment shown in FIG 2. The DZ-IG heat treatment was performed under a N₂ gas atmosphere containing 3% O₂. Next on the surface of the DZ-IG wafer, an epitaxial layer of n-type silicon single crystal having a resistivity of 10Ω·cm was epitaxially grown so as to have a thickness of 10 µm. Thus a DZ-IG epi-wafer was obtained.

### Comparative Example 2

An epitaxial wafer was obtained by epitaxial growth of an n-type silicon single crystal having a resistivity of 10Ω·cm and a thickness of 10 µm on the surface of an n-type silicon single crystal wafer sliced from an ingot of Example 1. Different from Example 1, a polycrystalline silicon layer was not formed on the back surface of the wafer.

### Comparative Example 3

An epitaxial wafer was obtained by epitaxial growth of arn n-type silicon single crystal having a resistivity of 10 Ω·cm and a thickness of 10 µm on the surface of an n-type silicon single crystal wafer sliced from an ingot of Comparative Example 1. Different from DZ-IG epi-wafer obtained in Comparative Example 1, a DZ-IG two-step heat treatment was not performed on the wafer.

### Comparative Testing 1

Using epi-wafers obtained by Example 1 and Comparative Examples 1 through 3 as samples, each sample was subjected to a heat treatment for simulating a CCD production process. In this heat treatment simulation, the early stage of device production, intermediate stage, and final stage were respectively simulated. After each step of early stage of device process, intermediate stage, and final stage, sample wafer was extracted. Each sample was divided into a tablet along a cleavage, and the cleaved wafer was subjected to selective chemical etching (wright etching) of 2 µm so as to visualize oxide precipitates. Using these samples, the density of oxide precipitates on the sectional plane of the wafer was measured using an optical microscope. The result is shown in FIG. 3. The term "as Epi" in FIG. 3 denotes a result of measurement of the oxide precipitates density of each wafer after the epitaxial growth and before the heat treatment. The down arrows in FIG 3 respectively show that the oxide precipitate density of as Epi, and oxygen precipitation density of Comparative example are respectively below the detection limit.

As is obvious from FIG 3, in the epi-wafer of Comparative Example 2, oxide precipitates were not observed in the early stage of the device process, whereas oxide precipitates providing a sufficient gettering effect were observed in the intermediate stage of the device process. In the epi-wafer 3 of Comparative Example 3, the oxide precipitate density did not reach a level sufficient for gettering even at a final stage of the device process. On the other hand, in the DZ-IG epi-wafer of Comparative Example 1, and epi-wafer of Example 1, oxide precipitate densities of not less than 5×10⁹particles /cm³ sufficient for providing gettering ability were observed from the early stage of device production.

### Comparative Testing 2

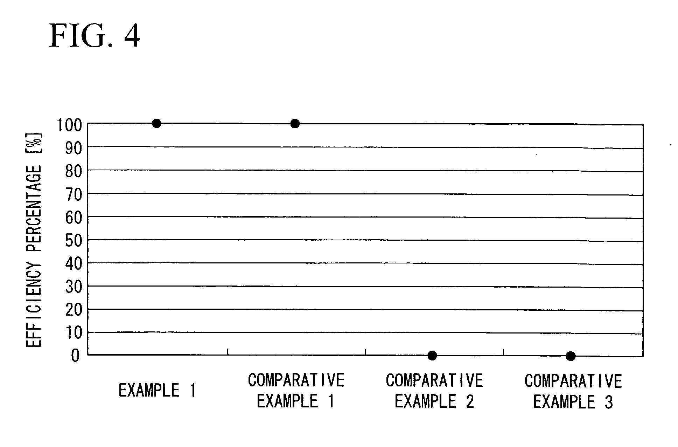

Surfaces of the epi-wafers obtained by Example 1 and Comparative Examples 1 through 3 were respectively contaminated by compulsion with Ni in a concentration of 1×10¹²atoms/cm². Next, the compulsively Ni-contaminated epi-wafers were respectively subjected to the heat treatment simulation of the Comparative Testing 1 simulating the CCD production process to the final stage. After the heat treatment simulation, each epi-wafer was subjected to evaluation of dielectric strength of the oxide film based on TZDB (Time Zero Dielectric Breakdown) under the conditions of a gate oxide film of 10 nm, and evaluation voltage of 8MV/cm. Efficiency percentage in this testing is shown in FIG. 4.

As is obvious from FIG 4, in the epi-wafer of Comparative Examples 2 and 3, all tips experienced dielectric breakdown and the efficiency percentages were 0%. On the other hand, in Example 1 and Comparative Example 1, all the tips showed satisfactory results, that is, the efficiency percentage was 100%. It can be interpreted that the epi-wafers of Example 1 and Comparative Example 1 had a sufficient gettering effect at an early stage of the device process, and defects were not formed on the surface of the epi-wafers. On the other hand, it is interpreted that Ni silicide was present in epi-wafers of Comparative Example 2 and Comparative Example 3 because of insufficient gettering, and showed a deteriorated dielectric strength of the oxide film.

Next, p/p- and p/p+ wafers comprising a carbon-doped p-type wafer and a polycrystalline silicon layer formed on the wafer were prepared. These wafers were subjected to a simulation-heat treatment equivalent to a CMOS image sensor process production process to a final stage. After the heat treatment simulation each wafer was subjected to evaluation of the dielectric strength of the oxide film based on TZDB. As a result all the tips showed satisfactory results, that is, the efficiency percentage was 100%. Thus, it was confirmed that the epi-wafer according to the present invention comprising a carbon-doped wafer, a polycrystalline silicon layer formed on the back surface of the wafer, and an epitaxial layer formed on the front surface of the wafer provides high-yields even in a epi-wafer having a base of a p-type wafer.

### INDUSTRIAL APPLICABILITY

An epitaxial wafer according to the present invention provides a sufficient IG effect by the formation of oxide precipitates during an early stage of the production process of an imaging device, and further provides an EG effect by the polycrystalline silicon layer. Therefore, the epitaxial wafer has an optimum applicability to the production of an imaging device which is sensitive to heavy metal contamination, and contributes to improvement of the yield.

A method for producing an epitaxial wafer according to the present invention enables the production of epitaxial wafers at lower cost than that of the DZ-IG wafer which requires a high production cost and has a high possibility of heavy metal contamination occurring during its production process. In addition, since there is no need for a high temperature heat treatment, contamination with heavy metals does not occur during the production process of the wafers and a strong gettering effect is expected from the early stage of the production process of the imaging device.

## Claims

1. A silicon epitaxial wafer comprising:
a silicon single crystal wafer sliced from a CZ silicon ingot doped with carbon in a concentration range of not less than 5×10¹⁵atoms/cm³ and not more than 5×10¹⁷ atoms/cm³ based on analysis in accordance with ASTM F123-1981;
an epitaxial layer consisting of a silicon single crystal epitaxially grown on a front surface of the silicon single crystal wafer; and
a polycrystalline silicon layer having a thickness of not less than 0.5 µm and not more than 1.5 µm and is formed on a back surface of the silicon single crystal wafer.

2. A method for producing a silicon epitaxial wafer comprising:
preparing a silicon single crystal wafer sliced from a CZ silicon ingot doped with carbon in a concentration range of not less than 5×10¹⁵atoms/cm³ and not more than 5×10¹⁷atoms/cm³ based on analysis in accordance with ASTM F123-1981;
forming a polycrystalline silicon layer having a thickness of not less than 0.5 µm and not more than 1.5 µm on a back surface of the silicon single crystal wafer and forming oxygen precipitation nuclei in an interior portion of the silicon single crystal wafer; and
epitaxially growing an epitaxial layer consisting of a silicon single crystal on a front surface of the silicon single crystal wafer.
